# FASCICULE DE BREVET EUROPEEN

(11) **EP 1 520 057 B1**
(45) Date de publication et mention de la délivrance du brevet: **03.01.2007**
(21) Numéro de dépôt: 03762722.1
(22) Date de dépôt: 01.07.2003
(51) Int. Cl.: C22C 47/14

(54) **PROCEDE DE FABRICATION D'UN PRODUIT COMPOSITE ET EN PARTICULIER D'UN DRAIN THERMIQUE**
VERFAHREN ZUR HERSTELLUNG EINES VERBUNDKÖRPERS, INS BESONDERE KÜHLKÖRPER
METHOD OF MAKING A COMPOSITE PRODUCT AND IN PARTICULAR A HEAT SINK

(30) Priorité: 04.07.2002 FR 0208396
(43) Date de publication de la demande: 06.04.2005
(73) Titulaire: CENTRE NATIONAL DE LA RECHERCHE SCIENTIFIQUE (CNRS), 75016 Paris (FR); Thermidrain, 33610 Cestas (FR)
(72) Inventeur: SILVAIN, Jean-Francois, F-33610 CESTAS (FR); BARBIER, Jean-Eric Rés. Montesquieu,Bat.15 Appt627, F-33700 MERIGNAC (FR); DESPAGNE, Philippe, F-33750 CARMASAC (FR); GEFFROY, Pierre-Marie, F-22140 PLUZUNET (FR)
(74) Mandataire: Domenego, Bertrand
(86) Numéro de dépôt international: PCT/FR2003/002043
(87) Numéro de publication internationale: WO 2004/005566

(56) Documents cités:
- EP-A- 0 709 476
- EP-A- 1 168 438
- WO-A-01/92594
- US-A- 5 561 829
- US-A- 5 601 924

## Description

L'invention concerne un procédé de fabrication d'un produit composite et en particulier d'un drain thermique utilisé dans des montages électroniques.

Il est connu d'utiliser, dans des montages électroniques, pour dissiper la chaleur des composants électroniques, des produits en matériau composite, appelés drains thermiques, qui peuvent être par exemple sous forme de plaques, de boîtiers ou de profilés de formes plus ou moins complexes. De tels drains thermiques, qui sont fixés par exemple sur des plaques de circuits électroniques, sont utilisés dans tous les secteurs de l'électronique, dans la construction automobile et dans l'aéronautique.

Le matériau constitutif de ces drains thermiques doit présenter une bonne conductivité thermique et des propriétés de dilatation qui peuvent être contrôlées, de manière à limiter les contraintes, lors de variation de température du substrat sur lequel ils sont fixés.

On connaît en particulier de tels drains thermiques sous la forme de produits en matériau composite comportant une matrice constituée de cuivre ou d'un alliage de cuivre et des particules de carbone dispersées dans la matrice qui peuvent être constituées par des poudres de graphite ou des fibres de carbone coupées.

Pour fabriquer de tels matériaux composites cuivre-carbone (ou encore aluminium-carbone), on a proposé de réaliser une infiltration du métal en fusion dans une préforme en carbone, ce procédé étant décrit par exemple dans le EP-0.898.310.

Dans le EP-1.168.438, on décrit un procédé de fabrication d'un matériau composite par traitement d'un mélange de poudres constituées de particules de carbone et d'un métal tel que le cuivre ou l'argent sous forme moulée à une température supérieure au point de fusion du métal, pour obtenir une interphase à la surface des particules de carbone et une liaison des particules du corps moulé.

Une variante du procédé consiste à mettre en contact un corps moulé obtenu à partir des particules de carbone avec une poudre ou des particules de métal, à une température supérieure au point de fusion du métal.

Dans tous les cas, on produit une infiltration du métal fondu dans un corps en particules de carbone.

On a proposé également de fabriquer les produits en matériau composite par pressage isostatique de particules de diamant ou de fibres de carbone revêtues d'une couche du métal de la matrice métallique, par exemple du cuivre ou de l'aluminium. Le revêtement des particules de carbone par le métal de la matrice peut être réalisé par pulvérisation cathodique ou par un procédé électrochimique, comme décrit par exemple dans les demandes de brevet EP-0.660.400 et WO-99/00524.

Dans le WO-01/92594; on décrit un procédé du type pressage à chaud qui comporte le maintien de fibres de carbone revêtues et de poudre de cuivre dans un moule qui subit un cycle de température et de pression de plusieurs heures, sans pressage à froid préalable. Les fibres de carbone sont revêtues préalablement par du cuivre.

De tels procédés de revêtement par infiltration ou pressage à chaud ont l'inconvénient d'être très coûteux et difficiles à mettre en oeuvre dans le cadre d'une fabrication industrielle des drains thermiques, en particulier parce qu'ils requièrent des temps d'exécution très longs.

On a proposé plus généralement de fabriquer de tels produits en matériau composite pour drains thermiques par différents procédés de métallurgie des poudres mais ces procédés nécessitent généralement un revêtement préalable des poudres, de telle sorte qu'ils sont généralement coûteux.

Le but de l'invention est de proposer un procédé de fabrication d'un produit composite comportant une matrice constituée principalement de cuivre et de particules de céramiques constituées de fibres de carbone, dispersées dans la matrice, ce procédé étant peu coûteux et pouvant être mis en oeuvre facilement dans le cadre d'une fabrication industrielle.

Dans ce but, le procédé selon l'invention comporte les caractéristiques de la revendication 1.

Le procédé suivant l'invention peut présenter en outre les caractéristiques des revendications 2 à 16.

Afin de bien faire comprendre l'invention, on va maintenant décrire, en se référant aux figures jointes en annexe, la mise en du procédé selon l'invention et selon plusieurs variantes.

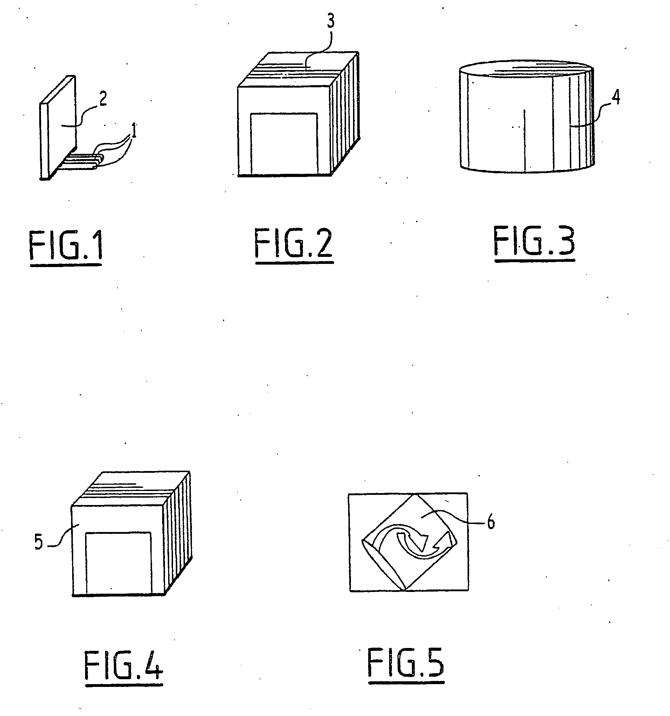

Les figures 1 à 9 sont des représentations schématiques de neuf étapes successives d'un procédé de fabrication de drains thermiques en matériau composite cuivre-carbone, sous la forme de produits plats tels que des bandes ou plaques.

Les produits de départ utilisés pour la fabrication des drains thermiques sont des poudres de cuivre et des fibres de carbone.

La poudre métallique destinée à constituer la matrice est principalement constituée de cuivre. Cette poudre peut être constituée de cuivre pur qui ne renferme d'autres éléments que le cuivre, qu'à titre d'éléments résiduels en très faible quantité et provenant de l'élaboration du cuivre. Le matériau de la poudre métallique peut être également un alliage de cuivre renfermant, de 0,1 à 10 atomes pour cent d'au moins un élément d'addition choisi parmi les éléments suivants : Al, Cr, Zr, Ti, Si, V, Mn, Hf, Fe, Y.

Dans tous les cas, la poudre métallique sera désignée par la suite comme poudre de cuivre, que cette poudre soit constituée de cuivre pur ou d'un alliage de cuivre. De préférence, la poudre de cuivre est constituée de particules à structure dendritique ou sensiblement dendritique qui peut être obtenue par exemple par électrolyse d'un sulfate de cuivre. Une telle structure dendritique des poudres de cuivre améliore la cohésion après pressage à froid et la densification du produit intermédiaire obtenu par pressage des poudres ainsi que la répartition des particules de carbone dans la matrice de cuivre du produit.

Dans tous les cas, on utilise du cuivre pur ou un alliage de cuivre, de manière à ce que la conductivité thermique de la matrice du produit soit la plus élevée possible et généralement proche de 400 W/mK. De manière typique, la poudre de cuivre peut présenter une granulométrie de l'ordre de 0,5 µm à 200 µm.

Les fibres de carbone peuvent être constituées par des fibres coupées de carbone ayant un diamètre compris entre 0,5 µm et 50 µm et une longueur comprise entre 50 µm et 5 mm. Les fibres de carbone du commerce sont généralement revêtues d'une couche de matériau époxy appelée ensimage, de manière à les protéger. Pour la mise en oeuvre du procédé suivant l'invention, les fibres de carbone peuvent être préalablement désensimées, comme il sera expliqué plus loin.

Les fibres peuvent être également utilisées sans être désensimées.

On va maintenant décrire un exemple de mise en oeuvre du procédé suivant l'invention en se référant aux figures.

Sur la figure 1, on a représenté de manière schématique une cisaille 2 de découpage des fibres de carbone 1 du commerce, par exemple sous forme de faisceaux de fibres. Comme indiqué plus haut, le découpage des fibres de carbone est réalisé de manière à obtenir des tronçons ayant une longueur comprise entre 50 µm et 5 mm.

Sur la figure 2, on a représenté un four 3 à l'intérieur duquel on réalise le désensimage des fibres coupées obtenues par découpage par élimination thermique de la couche de matériau époxy recouvrant les tronçons de fibres.

De manière typique, le four 3 réalise un désensimage des fibres à une température de l'ordre de 450°C pendant une durée de l'ordre de deux heures. Il est possible cependant de réaliser le désensimage des fibres à une température inférieure, par exemple de l'ordre de 300°C, avec un temps de maintien dans le four au moins égal à une heure, suivant l'épaisseur du revêtement d'époxy des fibres ; on peut également réaliser le désensimage en plongeant les fibres dans l'acétone pendant quelques heures.

Sur la figure 3, on a représenté un bac 4 dans lequel on réalise sur les fibres coupées qui ont un diamètre moyen de 6 µm et une longueur de 50 µm à 5 mm, un dépôt de chrome ou d'un sel de chrome par immersion des fibres avec agitation, dans un bain contenant un sel de chrome et de l'éthanol. On réalise l'immersion et l'agitation des fibres pendant quelques minutes à l'intérieur du bac 4, de telle sorte que les fibres se recouvrent d'une couche d'un composé de chrome, après séchage des fibres.

Il est possible également de recouvrir les fibres coupées par une couche de chrome ou d'un alliage ou composé de chrome obtenu par dépôt électrolytique, le bac 4 étant alors un bac d'électrolyse contenant une solution électrolytique à base de chrome.

L'agitation des tronçons de fibres dans le bac de revêtement 4 par un sel de chrome peut être réalisée par un malaxeur ou un broyeur à billes immargé dans le bac 4 ou par des pointes à ultrasons.

Les fibres revêtues sont extraites du bac 4 et introduites dans une étuve, à une température qui peut être de 80°C pendant une durée qui peut être de 10 mn. Les fibres coupées séchées sont ensuite placés dans un creuset en alumine. .

Sur la figure 4, on a représenté un four 5 dans lequel on réalise un traitement thermique des fibres à une température de 1000°C à 1200°C, pendant une durée de l'ordre d'une heure, sous un flux d'argon contenant environ 5 % d'hydrogène. La couche de sel de chrome déposée sur les tronçons de fibres se décompose en chrome et il se forme éventuellement du carbure de chrome à la surface des fibres pendant le traitement thermique. Cette technique permet d'obtenir des dépôts homogènes de chrome, d'alliage de chrome ou de carbure de chrome d'une épaisseur de 0,1 µm à 1 µm sur la surface des tronçons de fibres.

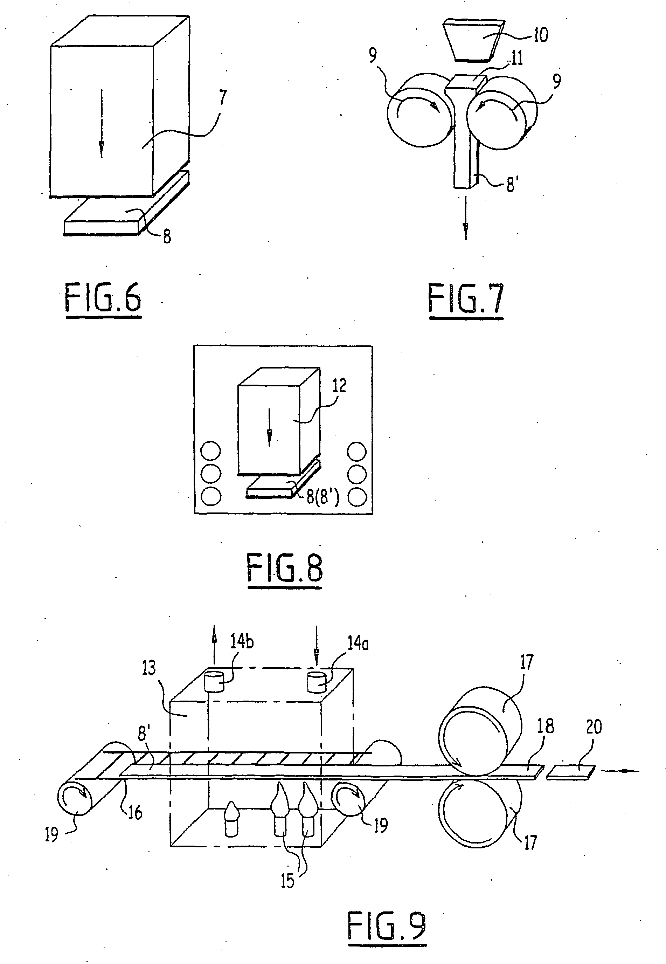

Sur la figure 5, on a représenté un mélangeur 3D 6 qui peut être un agitateur, par exemple un dispositif vendu sous la dénomination commerciale "TURBULA 3D". Le mélangeur 6 pourrait être également un mélangeur
ou un broyeur à bittes.

On introduit, dans le mélangeur 6, la poudre de cuivre et les particules de carbone, par exemple les fibres coupées revêtues d'une couche de chrome obtenue précédemment.

On introduit dans le mélangeur 6 de la poudre de cuivre, en une quantité représentant de 10 % à 90 % du volume total du mélange à réaliser et des particules de carbone représentant, en volume, de 10 % à 90 % du mélange à réaliser. On ajoute au mélange de poudre sèche qui représente de 95 % à 99,99 % du volume total introduit dans le mélangeur 6, 0,01 % à 5 % en volume d'un lubrifiant qui peut être par exemple une huile naturelle ou végétale telle que l'huile d'olive ou de tournesol ou une huile synthétique.

De manière typique, les proportions volumiques de la poudre de cuivre, des particules de carbone et du lubrifiant introduits dans le mélangeur peuvent être les suivantes : 0,1 % d'huile de tournesol ou autre lubrifiant, 59,9% de poudre de cuivre, 40 % de fibres de carbone coupées.

On peut également ajouter, au mélange de poudres, des billes de mélange en acier inoxydable, en acier non allié, en alumine, ou en zircone, de façon à casser les agrégats et améliorer l'homogénéité du mélange.

On réalise dans le mélangeur 6 un mélange homogène de la poudre de cuivre, des particules de carbone et du lubrifiant. Puis on introduit le mélange homogène obtenu à l'intérieur d'une presse à froid 7, comme représenté sur la figure 6. On réalise le pressage à froid, c'est-à-dire en fait à la température ambiante, par exemple de l'ordre de 15°C à 20°C, du mélange de poudre et de lubrifiant pour obtenir une plaque 8 constituant un produit intermédiaire dans la fabrication d'un drain thermique.

De manière typique, les poudres et le lubrifiant sont soumis à une pression de 200 à 600 MPa pendant l'étape de pressage à froid.

Le lubrifiant recouvrant les poudres permet d'améliorer l'homogénéité du produit intermédiaire obtenu par pressage à froid, du fait que la répartition des particules de carbone est facilitée par la présence du lubrifiant.

Comme représenté sur la figure 7, à titre de variante, en particulier dans le cas où le produit composite à obtenir est un produit plat tel qu'une bande ou une plaque, au lieu d'un pressage à froid du mélange de poudre et de lubrifiant, on peut effectuer un laminage à froid, c'est-à-dire à une température ambiante, par exemple de l'ordre de 15°C à 20°C, du mélange de poudre et de lubrifiant.

Sur la figure 7, on a représenté les cylindres 9 d'un laminoir à froid entre lesquels on introduit, par l'intermédiaire d'une trémie 10 et éventuellement d'un répartiteur 11, le mélange de poudre qui est déversé depuis la trémie 10 jusqu'à l'espace entre les cylindres par l'intermédiaire du répartiteur 11. On obtient, en sortie du laminoir, un produit intermédiaire 8' constitué par une bande compactée par laminage à froid qui peut être utilisée comme produit intermédiaire à la place d'une plaque 8 compactée à froid.

Comme il est visible sur la figure 8, on utilise une thermopresse 12 pour effectuer le forgeage à chaud de la plaque 8 obtenue par pressage à froid ou d'un tronçon de la bande 8' obtenue par laminage à froid, pour compacter et densifier le produit intermédiaire 8 (ou 8'). Le produit intermédiaire est porté à une température de forgeage à chaud comprise entre 450°C et 1000°C et de préférence proche de 800°C. La pression de forgeage à chaud est supérieure à 10 MPa et de préférence proche de 50 MPa. La pression est maintenue dans la thermopresse 12, sur le produit intermédiaire 8 ou 8', pendant une durée pouvant aller de 1 seconde à quelques minutes, de préférence sous une atmosphère contrôlée (neutre, réductrice ou sous vide) pour éviter l'oxydation de la poudre de cuivre.

Comme représenté sur la figure 9, à titre de variante, le produit intermédiaire tel que la bande laminée à froid 8' peut être compacté et densifié par laminage à chaud avec passage de la bande dans un four de chauffage 13 dans lequel on maintient une atmosphère de gaz neutre qui est introduit dans l'enceinte du four par un ajutage 14a, l'atmosphère du four étant évacuée en continu par un second ajutage 14b. La bande peut être chauffée par des brûleurs 15. La bande 8' qui a été précédemment compactée ou laminée à froid est soutenue à l'intérieur du four par une soie ou grille 16. A la sortie du four de chauffage, la bande est déplacée à l'intérieur du four par des rouleaux transporteurs 19, puis introduite à la température du four de chauffage entre des cylindres de laminage à chaud 17 qui assurent le compactage et la densification du produit 18 sous forme de bande.

Le produit est laminé à une température comprise entre 450°C et 1000°C et de préférence proche de 800°C.

La bande 18 densifiée par laminage à chaud est refroidie et découpée sous la forme de plaques 20 destinées à être utilisées comme drains thermiques.

Le travail à chaud de la bande peut être une opération de forgeage assurant uniquement une mise en compression du produit intermédiaire à une température de forgeage, comme il vient d'être décrit, ou encore une opération de forgeage ou matriçage entre des matrices donnant une forme particulière au produit composite final obtenu.

De même, le laminage peut être un simple laminage de produit plat, comme il a été décrit, ou encore un laminage entre cylindres cannelés pour obtenir un profilé d'une forme quelconque.

Le travail à chaud du métal peut être également un forgeage ou un matriçage complexe pour obtenir un produit mis en forme tel qu'un boîtier ou une partie de boîtier ou encore un élément d'échange thermique du type radiateur présentant des ailettes de refroidissement.

Après le travail à chaud, on peut soumettre le produit à un recuit sous atmosphère réductrice (par exemple mélange azote/hydrogène, ou hydrogène), à une température de 300°C à 500°C, pour relaxer les contraintes et éliminer les oxydes résiduels du produit.

Dans tous les cas, le procédé suivant l'invention qui combine un pressage à froid et un travail à chaud du produit intermédiaire obtenu par le pressage à froid de poudres de cuivre et de carbone en présence de lubrifiant permet d'obtenir un produit final pouvant constituer par exemple un drain thermique ayant un coefficient de dilatation thermique dans le sens longitudinal (dans le cas d'une plaque) de 6 à 12.10⁻⁶/°C. Ce coefficient de dilatation thermique peut être contrôlé par contrôle de la proportion de particules de carbone allant de 20 % à 50 % en volume dans le produit obtenu.

Dans le cas d'une plaque telle que le produit 20 obtenue à l'issue du forgeage ou du laminage à chaud, la conductivité thermique de la plaque est de 150 à 250 W/m.K dans le sens transversal et de 180 à 300 W/m.K dans le sens longitudinal.

La conductivité électrique de la plaque est de 2,1 à 3,5 µΩcm⁻¹ dans le sens longitudinal de la plaque et peut être contrôlée par contrôle de la proportion de particules de carbone.

On obtient donc, de manière simple et peu coûteuse, par un procédé facilement industrialisable, un drain thermique qui peut présenter la forme d'un produit plat ou toute autre forme telle qu'une forme profilée, par exemple une forme de gouttière, ou encore une forme-complexe, par exemple une forme de radiateur comportant des ailettes.

Les fibres de carbone peuvent être constituées par des nanotubes, c'est-à-dire des tubes de dimensions nanométriques, dont les longueurs peuvent être proches de celles des fibres coupées Les fibres céramiques de carbone utilisées pour la mise en oeuvre de l'invention qui doivent présenter une très bonne conductivité thermique peuvent être différentes de fibres de graphite. Ces fibres sous forme de tronçons de fibres ou de nanotubes peuvent être constituées principalement par du carbone sous d'autres formes que le graphite.

L'invention peut être utilisée en particulier pour obtenir tout substrat de montage électronique devant présenter en particulier une bonne conductivité thermique et électrique et un faible coefficient de dilatation thermique.

## Revendications

1. Procédé de fabrication d'un drain thermique (20) composite pour un circuit électronique, présentant une bonne conductivité thermique et un faible coefficient de dilatation thermique, comportant une matrice constituée de cuivre pur ou d'un alliage de cuivre, et des fibres de carbone dispersées dans la matrice, dans lequel :
- on prépare un mélange homogène d'une poudre de cuivre comprenant du cuivre pur ou un alliage de cuivre, et de fibres de carbone ;
- puis on réalise un pressage à froid du mélange de poudre de cuivre et de fibres de carbone, dans une presse à froid ou un laminoir à froid, pour obtenir un produit intermédiaire (8, 8') ;
- puis on densifie le produit intermédiaire (8. 8') par au moins une étape de travail à chaud à une température comprise entre 450°C et 1000°C, dans une presse de forgeage à chaud ou un laminoir à chaud.

2. Procédé selon la revendication 1, dans lequel on réalise le pressage à froid dans une presse à froid, et on densifie le produit dans une presse de forgeage à chaud.

3. Procédé selon la revendication 1, dans lequel on réalise le pressage à froid dans un laminoir à froid, et on densifie le produit dans une presse de forgeage à chaud ou un laminoir à chaud.

4. Procédé suivant l'une quelconque des revendications précédentes, **caractérisé par le fait que** la poudre de cuivre est constituée de particules à structure sensiblement dendritique.

5. Procédé suivant l'une quelconque des revendications précédentes, **caractérisé par le fait que** les fibres de carbone sont constituées par des tronçons de fibre de carbone ayant un diamètre compris entre 0,5 µm et 50 µm et une longueur comprise entre 50 µm et 5 mm, ou des nanotubes, ou encore de fibres constituées de nanotubes.

6. Procédé suivant l'une quelconque des revendications précédentes, **caractérisé par le fait que** le mélange homogène de la poudre de cuivre et des fibres de carbone est réalisé dans un mélangeur tel qu'un broyeur à billes, ou un mélangeur 30.

7. Procédé suivant la revendication 6, **caractérisé par le fait que**, pendant le mélange, on ajoute, au mélange de poudre de cuivre et de fibres de carbone, des billes de mélange en l'un des matériaux suivants : acier inoxydable, acier non allié, alumine, zircone.

8. Procédé suivant l'une quelconque des revendications précédentes, **caractérisé par le fait que** le pressage à froid est réalisé à une température ambiante.

9. Procédé suivant l'une quelconque des revendications précédentes, **caractérisé par le fait qu'**on densifie le produit intermédiaire (8, 8') par une étape de forgeage à chaud à une pression supérieure à 10 MPa, et de préférence proche de 50 MPa.

10. Procédé suivant l'une quelconque des revendications précédentes, **caractérisé par le fait qu'**on dépose une couche de chrome et/ou de carbure de chrome sur les fibres de carbone, avant le mélange avec la poudre de cuivre.

11. Procédé suivant la revendication 10. **caractérisé par le fait que** la couche de chrome et/ou de carbure de chrome déposée sur les fibres de carbone présente une épaisseur comprise entre 0.1 µm et 1 µm.

12. Procédé suivant la revendication 10 ou 11, **caractérisé par le fait qu'**on réalise le dépôt d'une couche d'un sel de chrome sur les fibres de carbone, par immersion et agitation des fibres de carbone dans un bain du sel de chrome, en présence d'éthanol, puis qu'on traite à une température comprise entre 1000°C et 1200°C, pendant une durée d'environ une heure, tes fibres de carbone recouvertes du sel de chrome, sous un flux d'argon renfermant environ 5 % d'hydrogène.

13. Procédé suivant l'une quelconque des revendications précédentes, **caractérisé en ce que**, dans l'étape de préparation d'un mélange, on ajoute un lubrifiant au mélange.

14. Procédé suivant la revendication 13, **caractérisé par le fait que** le mélange de poudre et de fibres de carbone renferme, en volume, de 10 % à 90 % de poudre de cuivre, de 10 % à 90 % de fibres de carbone ainsi qu'un lubrifiant constituant de 0.01 % à 5 % en volume du mélange de poudre de cuivre et de fibres de carbone.

15. Procédé suivant l'une quelconque des revendications précédentes, pour la fabrication d'un produit composite ayant l'une des formes suivantes : bande ou plaque, profilé, boîtier ou partie de boîtier, radiateur comportant des ailettes.

16. Procédé selon l'une quelconque des revendications précédentes, **caractérisé en ce que**, pendant l'étape de pressage à froid, on applique une pression comprise entre 200 et 600 MPa.

## Claims

1. Method of producing a composite thermal drain (20) for an electronic circuit, having good thermal conductivity and a low thermal expansion coefficient, comprising a matrix consisting of pure copper or a copper alloy, and carbon fibres dispersed in the matrix, wherein:
a homogeneous mixture of a copper powder containing pure copper or a copper alloy, and carbon fibres is prepared;
then the mixture of copper powder and carbon fibres is cold-pressed in a cold press or a cold rolling mill, to obtain an intermediate product (8, 8');
then the intermediate product (8, 8') is made denser by at least one hot working step at a temperature of between 450°C and 1000°C, in a hot forging press or a hot rolling mill.

2. Method according to claim 1, wherein the cold pressing is carried out in a cold press and the product is made denser in a hot forging press.

3. Method according to claim 1, wherein the cold pressing is carried out in a cold rolling mill and the product is made denser in a hot forging press or a hot rolling mill.

4. Method according to any one of the preceding claims, **characterised in that** the copper powder is made up of particles with a substantially dendritic structure.

5. Method according to any one of the preceding claims, **characterised in that** the carbon fibres consist of lengths of carbon fibres with a diameter of between 0.5 µm and 50 µm and a length of between 50 µm and 5 mm, or nanotubes, or fibres consisting of nanotubes.

6. Method according to any one of the preceding claims, **characterised in that** the homogeneous mixture of the copper powder and the carbon fibres is produced in a mixer such as a ball mill or a 3D mixer.

7. Method according to claim 6, **characterised in that**, during the mixing, mixed balls of one of the following materials: stainless steel, non-alloyed steel, aluminium or zirconium, are added to the mixture of copper powder and carbon fibres.

8. Method according to any one of the preceding claims, **characterised in that** the cold pressing is carried out at ambient temperature.

9. Method according to any one of the preceding claims, **characterised in that** the intermediate product (8, 8') is made denser by a hot forging step at a pressure greater than 10 MPa, preferably about 50 MPa.

10. Method according to any one of the preceding claims, **characterised in that** a coating of chromium and/or chromium carbide is deposited on the carbon fibres before they are mixed with the copper powder.

11. Method according to claim 10, **characterised in that** the coating of chromium and/or chromium carbide deposited on the carbon fibres has a thickness of between 0.1 µm and 1 µm.

12. Method according to claim 10 or 11, **characterised in that** a coating of chromium salt is deposited on the carbon fibres by immersion and agitation of the carbon fibres in a bath of the chromium salt, in the presence of ethanol, then the carbon fibres covered with the chromium salt are treated at a temperature of between 1000°C and 1200°C for a period of about one hour, under a current of argon containing about 5% of hydrogen.

13. Method according to any one of the preceding claims, **characterised in that** during the step of preparing a mixture a lubricant is added to the mixture.

14. Method according to claim 13, **characterised in that** the mixture of powder and carbon fibres contains, by volume, 10% to 90% of copper powder, 10% to 90 % of carbon fibres and a lubricant consisting of 0.01% to 5% by volume of the mixture of copper powder and carbon fibres.

15. Method according to any one of the preceding claims, for the production of a composite product taking one of the following forms: strip or sheet, section, housing or housing part, radiator with fins.

16. Method according to any one of the preceding claims, **characterised in that** a pressure of between 200 and 600 MPa is applied during the cold pressing step.

## Patentansprüche

1. Verfahren zur Herstellung einer Vorbundwärmeableitung (20) für eine elektronische Schaltung, die eine gute Wärmeleitfähigkeit und einen geringen Wärmedehnungskoeffizienten aufweist, umfassend eine Matrix, die aus reinem Kupfer oder einer Kupferlegierung besteht, und Kohlenstofffasern, die in der Matrix verstreut sind, bei dem:
- ein homogenes Gemisch aus einem Kupferpulver, umfassend reines Kupfer oder eine Kupferlegierung, und aus Kohlenstofffasern hergestellt wird;
- dann ein Kaltpressen des Gemisches aus Kupferpulver und Kohlenstofffasern in einer Kaltpresse oder einem Kaltwalzwerk durchgeführt wird, um ein Zwischenprodukt (8, 8') zu erhalten;
- dann das Zwischenprodukt (8, 8') durch mindestens einen Heißarbeitsschritt bei einer Temperatur zwischen 450 °C und 1000 °C in einer Heißschmiedepresse oder einem Heißwalzwerk verdichtet wird.

2. Verfahren nach Anspruch 1, bei dem das Kaltpressen in einer Kaltpresse erfolgt und das Produkt in einer Heißschmiedepresse verdichtet wird.

3. Verfahren nach Anspruch 1, bei dem das Kaltpressen in einem Kaltwalzwerk erfolgt und das Produkt in einer Heißschmiedepresse oder einem Heißwalzwerk verdichtet wird.

4. Verfahren nach einem der vorhergehenden Ansprüche, **dadurch gekennzeichnet, dass** das Kupferpulver aus Teilchen mit im Wesentlichen dendritischer Struktur gebildet ist.

5. Verfahren nach einem der vorhergehenden Ansprüche, **dadurch gekennzeichnet, dass** die Kohlenstoff fasern von
Kohlenstolffaserabschnitten mit einem Durchmesser zwischen 0, 5 µm und 50 µm und einer Länge zwischen 50 µm und 5 mm oder von Nanotuben oder auch von aus Nanotuben gebildeten Fasern gebildet sind.

6. Verfahren nach einem der vorhergehenden Ansprüche, **dadurch gekennzeichnet, dass** das homogene Gemisch des Kupferpulvers und der Kohlonstofffasern in einem Mischer, wie einer Kugelmühle oder einem 3D-Mischer hergestellt wird.

7. Verfahren nach Anspruch 6,
**dadurch gekennzeichnet, dass** während des Mischens dem Gemisch aus Kupferpulver und Kohlenstofffasern Mischkugeln aus einem der folgenden Stoffe beigemengt werden: rostfreier Stahl , nicht legierter Stahl, Aluminiumoxid, Zirkon.

8. Verfahren nach einem der vorhergehenden Ansprüche, **dadurch gekennzeichnet, dass** das Kaltpressen bei Raumtemperatur erfolgt.

9. Verfahren nach einem der vorhergehenden Ansprüche, **dadurch gekennzeichnet, dass** das Zwischenprodukt (8, 8') durch einen Heißschmiedeschritt bei einem Druck über 10 MPa und vorzugsweise nahe 50 MPa erfolgt.

10. Verfahren nach einem der vorhergehenden Ansprüche, **dadurch gekennzeichnet, dass** eine Schicht aus Chrom und/oder Chromkarbid auf die Kohlentofffasern vor dem Mischen mit dem Kupferpulver aufgebracht wird.

11. Verfahren nach Anspruch 10,
**dadurch gekennzeichnet, dass** die Schicht aus Chrom und/oder Chromkarbid, die auf die Kohlenstofffasern aufgebracht wird, eine Dicke zwischen 0,1 µm und 1 µm aufweist.

12. Verfahren nach Anspruch 10 oder 11,
**dadurch gekennzeichnet, dass** das Aufbringen einer Schicht eines Chromsalzes auf die Kohlenstofffasern Eintauchen und Schütteln der Kohlenstofffasern in einem Chromsalzbad im Beisein von Ethanol erfolgt, und dass dann bei einer Temperatur zwischen 1000 °C und 1200 °C während einer Dauer von ungefähr einer Stunde die mit dem Chromsalz überzogenen Kohlenstofffasern unter einem Argonstrom, der ungefähr 5 % Wasserstoff enthält, behandelt werden.

13. Verfahren nach einem der vorhergehenden Ansprüche, **dadurch gekennzeichnet, dass** in dem Schritt der Herstellung eines Gemisches dem Gemisch ein Schmiermittel hinzugefügt wird.

14. Verfahren nach Anspruch 13,
**dadurch gekennzeichnet, dass** das Gemisch aus Pulver und Kohlenstofffasern ungefähr 10 bis 90 Vol.-% Kupferpulver, 10 bis 90 Vol.-% Kohlenstofffasern sowie ein Schmiermittel umfasst, das 0,01 bis 5 Vol. -% des Gemisches aus Kupferpulver und Kohlenstofffasern ausmacht.

15. Verfahren nach einem der vorhergehenden Ansprüche für die Herstellung eines Vorbundproduktes, das eine der folgenden Formen aufweist: Band oder Platte, Profil, Gehäuse oder Gehäuseteil, Radiator mit Rippen.

16. Verfahren nach einem der vorhergehenden Ansprüche,
**dadurch gekennzeichnet, dass** während des Schrittes des Kaltpressens ein Druck zwischen 200 und 600 MPa angelegt wird.
